# EUROPÄISCHE PATENTSCHRIFT

(11) **EP 0 237 826 B1**
(45) Veröffentlichungstag und Bekanntmachung des Hinweises auf die Patenterteilung: **19.05.1993**
(21) Anmeldenummer: 87102395.8
(22) Anmeldetag: 19.02.1987
(51) Int. Cl.: H01L 21/28, H01L 29/76, H01L 29/80

(54) **Verfahren zur Herstellung eines selbstjustiert positionierten Metallkontaktes**
Method of making a self-aligned metallic contact
Procédé pour la fabrication d'un contact métallique auto-aligné

(30) Priorität: 19.03.1986 DE 3609274
(43) Veröffentlichungstag der Anmeldung: 23.09.1987
(73) Patentinhaber: SIEMENS AKTIENGESELLSCHAFT, 80333 München (DE)
(72) Erfinder: Willer, Josef, Dr., D-8042 Oberschleissheim (DE)

(56) Entgegenhaltungen:
- EP-A- 0 036 500
- EP-A- 0 113 161
- PATENT ABSTRACTS OF JAPAN, Band 10, Nr. 145 (E-407)(2202), 28. Mai 1986 ; & JP-A-61 006 871
- PATENT ABSTRACTS OF JAPAN, Band 6, Nr. 189 (E-133)(1067), 28. September 1982 ; & JP-A-57 103 364 .
- IBM TECHNICAL DISCLOSURE BULLETIN, Band 28, Nr. 3, August 1985, Seiten 916, 917, New York (USA) ; "Self-Aligned Recessed Gate Mesfet".
- IBM TECHNICAL DISCLOSURE BULLETIN, Band 28, Nr. 7, Dezember 1985, Seiten 2767, 2768, New York (USA) ; "Self-Aligned Dummy Gate Sedewall-Spaced Mesfet"
- SOLID STATE TECHNOLOGY, Band 29, Nr. 2, Februar 1985, Seiten 209-215.

## Beschreibung

Die vorliegende Erfindung bezieht sich auf ein Verfahren mit den Merkmalen des Oberbegriffes des Patentanspruches 1.

Seit mehr als einem Jahrzehnt ist es bekannt, auf Silizium als Halbleitermaterial selbstjustiert positionierte Metallkontakte, insbesondere Gate-Kontakte herzustellen, wobei diese Justierung bezogen ist auf ein Source- und/oder Drain-Gebiet, einen Source- und/oder Drain-Kontakt, einen Gate-Bereich, Kanal-Bereich oder dgl.. Weit verbreitet ist die Anwendung lichtoptischer Fotolithographie mit Masken für Dotierungen und/oder Abscheidungen, auch von Metall für Kontakte und dgl., wobei Licht des im wesentlichen sichtbaren Wellenlängenbereiches verwendet wird. Bekanntermaßen ist für exakte und kantenscharfe Abbildung von Maskenstrukturen eine untere Grenze der Abmessungen gegeben, die in der Größenordnung der verwendeten Lichtwellenlänge liegt, so daß eine Dimension nicht mehr einwandfrei einzuhalten ist, die "merklich kleiner" als die Wellenlänge des bei der Fotolithographie verwendeten Lichtes ist.

Demgemäß lassen sich bei (alleiniger) Anwendung lichtoptischer Fotolithographie scharfe Konturen nur bis zu Abmessungen herab realisieren, die mindestens mehrere Zehntel µm groß bemessen sind.

Für III-V-Halbleitermaterial sind in Solid State Technologie (Febr. 1985), S. 209 bis 215 Einzelheiten zur Herstellung von Galliumarsenid-MESFET's angegeben. Der Gate-Kontakt hat dort eine (in Richtung zwischen Source und Drain gesehene) Abmessung von 1 µm. Mindestens entsprechend große Abstände bestehen zwischen dem Gate-Kontakt und dem Source- bzw. Drain-Kontakt.

Ein Verfahren zur Herstellung eines selbstjustiert positionierten Metall-Gate-Kontakts auf III-V- Halbleitermaterial ist aus der EP-A-0 113 161 bekannt. Bei diesem Verfahren werden auf einer für den Gate-Bereich vorgesehenen aktiven Schicht eine Metallschicht als ohmsche Kontaktelektroden für Source und Drain und darauf ein Spacerfilm aus Aluminium aufgebracht. Die aktive Schicht wird mittels Lift-off im Gate-Bereich freigelegt und in der Öffnung isolierende sidewall spacers hergestellt. Danach wird die Aluminiumschicht entfernt und ganzflächig eine dünne Platinschicht so aufgebracht, daß sie an den dem Gate-Bereich abgewandten Kanten der Spacer abreißt. Schließlich werden die Spacer mit den darauf befindlichen Anteilen der Platinschicht entfernt.

Weiterer Stand der Technik ist beschrieben in IEDM (1964), S. 194 bis 197, GaAs IC Symp. Tech. Digest (1983), S. 138 bis 141, Extended Abstracts of the 15th Conference on Solid State Devices and Materials, Tokyo 1983, S. 69 bis 72, 12th Intern. Symp. on GaAs and related compounds, Karuizawa, 1985, IEE ED-32 (1985), S. 848 bis 850, Electronics Letters, Bd. 21 (1985), S. 804 bis 805 und GaAs IC Symp., IEE (1984), S. 121. Lediglich mit der Herstellung eines hochtemperaturbeständigen Kontaktes ist die EP-A-01 30 416 befaßt.

Aufgabe der vorliegenden Erfindung ist es, Maßnahmen anzugeben, mit deren zusätzliche Anwendung lichtoptische Fotolithographie zur Herstellung von Strukturen angewendet werden kann, und zwar auch mit solchen Abmessungen, die (wie schon oben definiert) merklich kleiner als die Wellenlänge des bei der Fotolithographie verwendeten Lichts sind. Mit der Erfindung sollen insbesondere (Schottky-) Gate-Kontakte herstellbar sein, deren Abmessung, gesehen in der Richtung zwischen Source und Drain und/oder deren Abstand zum benachbarten Source- und/oder Drain-Gebiet bzw. -Kontakt nur wenige Zehntel µm bis herab zu 0,1 µm betragen.

Dieses Verfahren soll nach dem Prinzip der Selbstjustierung durchführbar sein.

Diese Aufgabe wird mit einem Verfahren gemäß den Merkmalen des Patentanspruches 1 bzw. mit Hilfe der Verfahren nach den Unteransprüchen gelöst.

Das erfindungsgemäße, für Elektronikbauelemente mit III-V-Halbleitermaterial durchzuführende Verfahren, sieht zum einen die Anwendung von Maßnahmen üblicher lichtoptischer Fotolithographie vor. Bei der Erfindung ist jedoch als wichtige zusätzliche Maßnahme vorgesehen, daß im Verlaufe der Durchführung der vorgesehenen Verfahrensschritte auf der Halbleiteroberfläche eine Kontaktmaske, d.h. eine die Halbleiteroberfläche kontaktierende Abdeckstruktur entsteht und für mindestens einen weiteren Verfahrensschritt vorliegt, wobei diese Struktur ein unterschiedliches Maß der Maskierung hat für maskiertes isotropes bzw. im wesentlichen ungerichtetes maskiertes Abscheiden und b) für anisotropes, gerichtetes Abtragen hat. Zu den Verfahrensschritten gemäß a) gehört das CVD-Verfahren. Zu dem Verfahrensschritt b) gehört das Trockenätzen, wie Ionenätzen, reaktives Ionenätzen und dgl..

Weitere Erläuterungen der Erfindung gehen aus den nachfolgend beschriebenen Verfahrensabläufen und deren jeweilige Varianten hervor.

Ein erster Verfahrensschritt ist die Bereitstellung des III-V-Halbleitermaterials 1, das in voneinander verschiedener Beschaffenheit vorliegen kann. Zum Beispiel i) kann das Halbleitermaterial ein Substratkörper, ggf. mit darauf befindlicher Halbleiterepitaxieschicht, sein, wobei das Halbleitermaterial keine Dotierung oder keine derartige Dotierung aufweist, wie sie für einzelne Bereiche des herzustellenden Bauelements erforderlich ist. Zum Beispiel j) kann das Halbleitermaterial 11 jedoch bereits ein solches sein, das zumindest in dem in Frage kommenden oberflächennahen Bereich bereits eine solche Dotierung aufweist, wie sie für Source- und Drain-Gebiet erforderlich bzw. vorgegeben ist und wobei diese Dotierung bereits ausgeheilt ist.

Für den Fall i) folgt für das betreffende Beispiel die Erzeugung einer für den Gate- bzw. Kanal-Bereich vorgegebenen Grunddotierung in der oberflächennahen Schicht 5 des Halbleitermaterials.

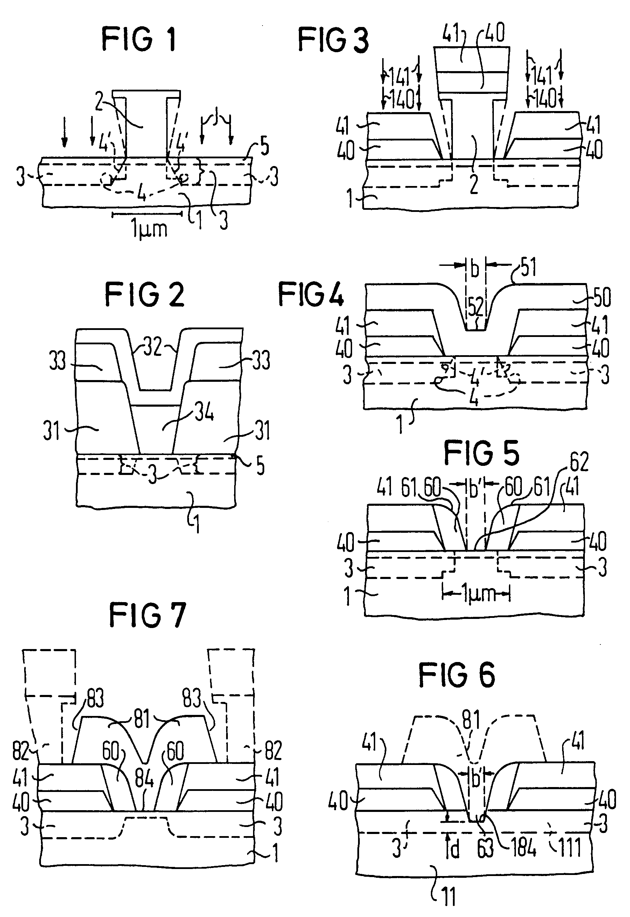

Als nächster Verfahrensschritt für die Fälle i) und j) folgt die Anwendung einer lichtoptischen Fotomaskentechnik, z.B. mit Hilfe von Fotolack. Das Ergebnis ist ein Maskierungselement 2, wie es Figur 1 in zwei Varianten (Seitenkanten der zweiten Variante gestrichelt dargestellt) zeigt. Die Form der (mit ausgezogenen Linien dargestellten) ersten Variante entsteht dadurch, daß sog. Einlagen-Fototechnik durchgeführt wird, die zu einer Überhang-Stufe im Bereich der Oberfläche der ursprünglich aufgebrachten Fotolackschicht führt. Man erreicht dies bekanntermaßen dadurch, daß vor dem Entwickeln der Fotolackschicht eine "Härtung" der oberflächennahen Schicht der Fotolackschicht z.B. mittels Chlorbenzol erfolgt.

Dieser Verfahrensschritt kann auch in Mehrlagen-Fototechnik ausgeführt werden.

Eine wie gestrichelt dargestellte Kontur der zweiten Variante läßt sich erreichen mittels Anwendung der in IBM Techn. Discl. Bulletin, Bd. 26 (1984), S. 6506/6507 beschriebenen Verfahren oder durch ein "reziprokes" Verfahren, bei dem im lichtoptischen Fotoverfahren eine Aussparung der Fotolackschicht ebenfalls entsprechend der Form der zweiten Variante hergestellt wird, wobei sich schräge (gestrichelt dargestellte) Seitenflanken bei Fotolack zwangsläufig ergeben.

Die letztgenannte Variante mit "reziproker" Maske wird in der Weise ausgeführt, daß (siehe Figur 2) über die zuvor strukturierte Fotolackschicht 31 anisotrop, d.h. gerichtet, eine Hilfsschicht mit der Oberflächenkontur 32, z.B. aus Metall, aufgebracht wird. Nach daraufhinfolgendem isotropen Rückätzen verbleiben die Schichtanteile 33 und 34, wobei der Anteil 34 das Maskierungselement 2 der Figur 1 in der zweiten Variante ist. Nach Entfernen des Fotolacks 31 ist hinsichtlich des Maskierungselements 2 auch nach dieser Variante der Zustand der Figur 1 erreicht.

In Figur 1 ist für den Fall i) die für diesen Fall nachfolgende strukturierte Implantierung J gezeigt, die zu den dotierten Source/Drain-Gebieten 3 führt, wobei auf die dargestellte, zwangsläufig entstandene Stufe 4 (Schräge 4' für die gestrichelte Form des Maskierungselements 2) hingewiesen sei.

Für den Fall j) bedarf es diesen Verfahrensschrittes nicht, da in diesem Falle bereits von entsprechend Source/Drain-dotiertem Halbleitermaterial ausgegangen worden ist.

Die Figur 3 zeigt das mit dem Maskierungselement 2 erfolgende Abscheiden 140 des Kontaktmetalls für die Source/Drain-Kontakte. Diese Abscheidung kann durch gerichtetes Aufdampfen, gerichtetes Sputtern und dgl. erfolgen. Es führt zu den Kontakten 40. Anschließend wird wieder mit der Maskierung durch das Element 2 eine für Abhebetechnik (lift off) geeigneten Schicht 41 aus beispielsweise Siliziumdioxid abgeschieden (141). Auch diese Schicht hat dann schon die dargestellte Strukturierung. Dann wird die Maske mit den darauf befindlichen Anteilen der Schichten 40, 41 entfernt.

Der nächste für beide Fälle i) und j) gültige Verfahrensschritt ist das isotrope Aufbringen bzw. Abscheiden, z.B. nach einem CVD-Verfahren, einer Maskierungsschicht 50 aus z.B. Siliziumdioxid (Fig.5). Die Oberflächenstruktur dieser Schicht 50 ist mit 51 bezeichnet. Die Schichtdicke ist so gewählt, daß sich eine tiefe Einsenkung 52 ergibt, deren (in der Figur 4 sichtbare) Breite b erheblich geringer ist, als der Abstand der Flanken der Schichtanteile 40 (und 41).

Figur 5 zeigt das Ergebnis eines als nächster Verfahrensschritt durchgeführten anisotropen, d.h. gerichteten, Rückätzens nach z.B. einem Trockenätzverfahren. Zweckmäßig ist die Anwendung von Ionenätzen oder auch reaktivem Ionenätzen gemäß bekannter Vorschriften für das für die Schicht 50 verwendete Material. Von der Schicht 50 verbleiben nur noch die mit 60 bezeichneten Reste, die eine Oberflächenkontur 61 haben. Das Rückätzen wird so weit durchgeführt, daß die ursprüngliche Oberfläche 62 des Halbleitermaterials 1 freiliegt, und zwar in einer in der Figur 5 gezeigten Breite bʹ (zwischen den Fußpunkten der Konturen 61) von z.B. nur 0,3 bis 0,1 µm bei z.B. 1 µm Abstand zwischen den Kanten der beiden einander gegenüberstehenden Kontaktschichtanteilen 40.

Figur 6 zeigt die durch Figur 5 beschriebenen Maßnahmen in der statt für den Fall i) in der für den Fall j) anzuwendenden Variation. Der Unterschied gegenüber den Maßnahmen gemäß Figur 5 besteht in der Erzeugung einer Vertiefung 63 im Halbleitermaterial 11, wobei diese Vertiefung 63 durch das bereits beschriebene Rückätzen miterzeugt werden kann. Die Tiefe dieser Vertiefung 63 ist so bemessen, daß sie zu einer Verringerung der Dicke des Dotierungsbereiches 111 führt, wobei dieser Dotierungsbereich die Dotierung des Ausgangsmaterials des Falles j) ist. Diese Dickenverringerung liefert den für den Gate-Bereich den gegenüber Source/Drain-Bereich vorteilhaften Dotierungsunterschied.

Die Erzeugung eines solchen Rücksprunges 63 ist insbesondere für Bauelemente mit vorgegeben niedriger Einsatzspannung und für den normally-off-Typ für große und kleine Einsatzspannungen von Interesse.

Für den Fall i) folgt als weiterer Verfahrensschritt das Ausheilen der damage-Schäden des Implantierungsprozesses I und ggf. aufgetretener damage-Schäden des vorangegangenen Rückätzens. Dies kann nach einem flash-anneal-Verfahren oder mit üblichem Tempern erfolgen. Zusammen mit diesem Ausheilen erfolgt auch das Einlegieren des Metalls der Source/Drain-Kontakte und das Aktivieren derselben. Die Maßnahme des Ausheilens kann auch schon vor dem Verfahrensschritt des Rückätzens durchgeführt werden, nämlich soweit damage-Schäden des Rückätzens eine unwesentliche Rolle spielen.

Figur 7 zeigt die endgültige Struktur mit dem gemäß dem nächsten Verfahrensschritt angebrachten Schottky-Kontakt 81. Dieser Verfahrensschritt erfolgt unter Zuhilfenahme einer Maskierung 82 für die Außenränder 83 des Kontakts 81. Der eigentliche wichtige Anteil des Kontakts 81, nämlich der Schottky-Übergang 84 ist durch den zweiten Selbstjustierungsvorgang dieses Verfahrens genau justiert und symmetrisch zu den Source/Drain-Bereichen 3 und den Source/Drain-Kontakten 40.

Der Gate-Kontakt 81 kann auch nach einem Verfahren der Abhebetechnik oder durch zuvor ganzflächige Metallisierung mit anschließendem Rückätzen erzeugt sein.

Der erst mit den Maßnahmen gemäß Figur 7 entstehende Schottky-Übergang ist (mit 184 bezeichnet) in Figur 6 bereits dargestellt. Er liegt in der Vertiefung 63, die für den Fall j vorgesehen ist.

Es können während des Ablaufs eines erfindungsgemäßen Verfahrens auch Passivierungsschichten in bekannter Weise vorgesehen bzw. verwendet werden. Insbesondere kann die Verwendung einer Passivierungsschicht im Zusammenhang mit dem Verfahrensschritt des Ausheilens vorgesehen sein, nämlich um bei z.B. Galliumarsenid eine Gegenmaßnahme gegen zu starke Arsenabdampfung anzuwenden (um einen Arsengegendruck entbehrlich zu machen).

Für den Fall i) ist als Metall für den Source/Drain-Kontakt 40 hochtemperaturbeständiges Metall erforderlich. Hierfür eignet sich z.B. eine Schichtfolge aus Germanium und darauf Wolfram oder Molybdän oder Tantal. Für den Schottky-Kontakt 84, 184 empfiehlt sich z.B. eine Titan-Platin-Gold-Kombination.

"Lichtoptisch" im Sinne der vorliegenden Erfindung erstreckt sich auch bis in den kurzwelligen Ultraviolett-Bereich, z.B. bis zu 200 nm bzw. bis in den Bereich der Excimer-Laser.

Ein mit der Erfindung zu erzielender wesentlicher Vorteil ist, daß, wie auch die Figur 7 deutlich zeigt, ohne Schwierigkeiten ein relativ großer (Gate-)Kontakt 81 mit sehr kleinem Zuleitungswiderstand herzustellen ist, obwohl die Abmessung der Länge bʹ, d.h. die eigentliche Gate-Länge sehr klein, z.B. nur 0,2 µm groß ist.

Der Vollständigkeit halber sei darauf hingewiesen, daß der Gate-Kontakt 84, 184 mit sehr geringer Länge in Richtung senkrecht zur Darstellungsebene der Figuren dem gegenüber auch sehr große Abmessung haben kann, z.B. Streifenform besitzen kann. Es lassen sich damit Gate-Kontakte für Leistungs-FET's mit Gate-Längen (bʹ) im Submikronbereich und mit Streifenlänge bis zu einigen mm herstellen.

## Patentansprüche

1. Verfahren zur Herstellung eines Metallkontaktes (81) auf Halbleitermaterial (1, 11) zwischen zwei weiteren Kontakten (40), die voneinander einen Abstand von höchstens 1 µm haben und bezüglich derer der Metallkontakt (81) selbstjustiert positioniert und elektrisch isoliert ist, unter Anwendung lichtoptischer Fotomaskentechnik,
bei dem in einem ersten Schritt auf dem Halbleitermaterial (1, 11) unter Verwendung eines auf diesem Halbleitermaterial positionierten Maskierungselements (2) mit hinterschnittener Form durch gerichtetes Abscheiden (140) das Metall der Kontakte (40) aufgebracht wird,
bei dem in einem zweiten Schritt darüber durch gerichtetes Abscheiden (141) unter Verwendung dieses Maskierungselementes (2) eine für Lift-off geeignete Schicht (41) aus Siliziumdioxid aufgebracht wird,
bei dem in einem dritten Schritt das Maskierungselement (2) entfernt wird und durch isotropes Abscheiden ganzflächig eine Schicht (50) aus elektrisch isolierendem Material aufgebracht wird,
bei dem in einem vierten Schritt durch anisotropes Rückätzen diese isolierende Schicht (50) bis auf Flankenanteile (60) entfernt wird, wobei zwischen diesen Flankenanteilen (60) die Oberfläche (62) des Halbleitermaterials (1, 11) auf eine Breite (b') von höchstens 0,3 µm freigelegt wird und bei dem in einem fünften Schritt auf diese Oberfläche (62) des Halbleitermateriales (1, 11) zwischen die Flankenanteile (60) das Material des Metallkontaktes (81) so weit aufgebracht wird, daß die Flankenanteile (60) vollständig und die verbliebenen Anteile der für Lift-off geeigneten Schicht (41) teilweise davon bedeckt werden.

2. Verfahren nach Anspruch 1,
bei dem der Metallkontakt (81) als Gate-Kontakt eines Feldeffekttransistors und die weiteren Kontakte (40) als Source- und Drain-Kontakt dieses Feldeffekttransistors aufgebracht werden und das Material des Metallkontaktes (81) an der Oberfläche (62) des Halbleitermaterials (1, 11) einen Schottky-Übergang (84, 184) bildet.

3. Verfahren nach Anspruch 2,
bei dem vor dem ersten Schritt in einer oberflächennahen Schicht (5) des Halbleitermateriales (1) eine für einen Gate-Bereich vorgesehene Grunddotierung erzeugt wird, dann das Maskierungselement (2) hergestellt wird, dann mit Hilfe dieses Maskierungselementes (2) eine strukturierte Implantierung (I) zur Herstellung der Source-/Drain-Gebiete (3) vorgenommen wird und in einem der nachfolgenden Schritte die durch diese Implantierung herbeigeführten Damage-Schäden ausgeheilt werden.

4. Verfahren nach Anspruch 2,
bei dem vor dem ersten Schritt in einer oberflächennahen Schicht des Halbleitermateriales (11) ein Dotierungsbereich (111) mit einer für die Source- und Drain-Gebiete (3) vorgesehenen Dotierung hergestellt wird und zwischen dem vierten und fünften Schritt eine Vertiefung (63) in dem Halbleitermaterial (11) im Bereich der freigelegten Oberfläche (62) hergestellt wird, so daß durch diese Vertiefung (63) die Dicke des Dotierungsbereiches (111) im Gate-Bereich so verringert wird, wie dem Dotierungsunterschied zwischen dem Gate-Bereich und den Source- und Drain-Gebieten (3) entspricht.

5. Verfahren nach einem der Ansprüche 1 bis 4,
bei dem das Maskierungselement (2) fotolithografisch aus einer ganzflächig aufgebrachten Fotolackschicht hergestellt wird.

6. Verfahren nach einem der Ansprüche 1 bis 4,
bei dem das Maskierungselement (2) in der Weise hergestellt wird, daß auf der Oberfläche des Halbleitermateriales (1) zunächst ganzflächig eine Fotolackschicht aufgebracht wird, daß in dieser Fotolackschicht eine der Form des Maskierungselementes (2) entsprechende Aussparung erzeugt wird, daß dann auf die derart strukturierte Fotolackschicht (31) anisotrop eine Hilfsschicht aufgebracht wird und daß nachfolgend diese Hilfsschicht isotrop so weit rückgeätzt wird, daß nach dem Entfernen der Fotolackschicht (31) von der Hilfsschicht nur ein dem Maskierungselement (2) entsprechender Anteil (34) übrigbleibt.

## Claims

1. Method of producing a metal contact (81) on semiconductor material (1, 11) between two further contacts (40) which are spaced not more than 1 µm apart and with respect to which the metal contact (81) is positioned in a self-aligned manner and electrically insulated, use being made of light-optical photomask technology, in a first step of which method the metal of the contacts (40) is deposited on the semiconductor material (1, 11) by directional deposition (140) using a masking element (2) positioned on said semiconductor material and having an undercut shape, in a second step of which method a silicon dioxide layer (41) suitable for lift-off is deposited thereon by directional deposition (141) using said masking element (2), in a third step of which method the masking element (2) is removed and a layer (50) of electrically insulating material is deposited over the entire surface by isotropic deposition, in a fourth step of which method said insulating layer (50) is removed, with the exception of edge components (60), by anisotropic back-etching, the surface (62) of the semiconductor material (1, 11) between said edge components (60) being exposed to a width (b') of not more than 0.3 µm, and in a fifth step of which method the material of the metal contact (81) is deposited on said surface (62) of the semiconductor material (1, 11) between the edge components (60) to such an extent that it completely covers the edge components (60) and partly covers the remaining components of the layer (41) suitable for lift-off.

2. Method according to Claim 1, in which the metal contact (81) is deposited as a gate contact of a field-effect transistor and the further contacts (40) are deposited as a source and a drain contact of said field-effect transistor, and the material of the metal contact (81) on the surface (62) of the semiconductor material (1, 11) forms a Schottky junction (84, 184).

3. Method according to Claim 2, in which, before the first step, a basic doping provided for a gate zone is produced in a layer (5) of the semiconductor material (1) near the surface, the masking element (2) is then produced, a patterned implantation (I) to produce the source/drain regions (3) is carried out with the aid of said masking element (2), and, in one of the subsequent steps, the damage due to said implantation is annealed out.

4. Method according to Claim 2, in which, before the first step, a doping zone (111) having a doping provided for the source and drain regions (3) is produced in a layer of the semiconductor material (11) near the surface and, between the fourth and fifth steps, a recess (63) is produced in the semiconductor material (11) in the region of the exposed surface (62), with the result that said recess (63) reduces the thickness of the doping zone (111) in the gate zone to the extent corresponding to the doping difference between the gate zone and the source and drain regions (3).

5. Method according to one of Claims 1 to 4, in which the masking element (2) is produced photolithographically from a photoresist layer deposited over the entire surface.

6. Method according to one of Claims 1 to 4, in which the masking element (2) is produced by first depositing a photoresist layer over the entire surface of the semiconductor material (1), producing a recess corresponding to the shape of the masking element (2) in said photoresist layer, then depositing an auxiliary layer anisotropically on the photoresist layer (31) patterned in this way and subsequently back-etching said auxiliary layer isotropically to such an extent that, after the photoresist layer (31) has been removed, only a component (34) corresponding to the masking element (2) is left of the auxiliary layer.

## Revendications

1. Procédé pour fabriquer un contact métallique (81) sur un matériau semiconducteur (1,11) entre deux autres contacts (40), qui sont séparés par une distance égale au maximum à 1 µm et par rapport auxquels le contact métallique (81) est positionné en étant auto-aligné et est isolé du point de vue électrique, moyennant l'utilisation d'une technique optique utilisant un photomasque,
selon lequel, lors d'une première étape, on dépose au moyen d'un dépôt dirigé (140) le métal des contacts (40) sur le matériau semiconducteur (1,11) en utilisant un élément de masquage (2) positionné sur ce matériau semiconducteur et possédant une forme en dépouille,
selon lequel, lors d'une deuxième étape, on dépose sur l'ensemble précédent, au moyen d'un dépôt dirigé (141) et en utilisant cet élément de masquage (2), une couche de dioxyde de silicium (41), convenant pour l'opération Lift-off (décollement),
selon lequel, lors d'une troisième étape, on élimine l'élément de masquage (2) et on dépose sur toute la surface, au moyen d'un dépôt isotrope, une couche (50) en un matériau électriquement isolant,
selon lequel, lors d'une quatrième étape, on élimine, au moyen d'une gravure anisotrope, cette couche isolante (50) sauf sur des parties (60) des flancs, la surface (62) du matériau semiconducteur (1,11) étant mise à nu, entre ces parties (60) des flancs, sur une largeur (b') égale au maximum à 0,3 µm, et
selon lequel, lors d'une cinquième étape, on dépose le matériau du contact métallique (81) sur cette surface (62) du matériau semiconducteur (1,11) entre les parties (60) des flancs au point que les parties (60) des flancs sont complètement recouvertes et que les parties restantes de la couche (41) convenant pour l'opération Lift-off sont partiellement recouvertes.

2. Procédé suivant la revendication 1, selon lequel le contact métallique (81) est déposé en tant que contact de grille d'un transistor à effet de champ, et les autres contacts (40) sont déposés en tant que contacts de source et de drain de ce transistor à effet de champ et le matériau du contact métallique (81) forme, à la surface (62) du matériau semiconducteur (1,11), une jonction Schottky (84,184).

3. Procédé suivant la revendication 2, selon lequel, avant la première étape, on produit, dans une couche (5) proche de la surface du matériau semiconducteur (1), un dopage de base prévu pour une zone de grille, puis on fabrique l'élément de masquage (2), on réalise ensuite, à l'aide de cet élément de masquage (2), une implantation structurée (I) pour fabriquer les régions de source/drain (3) et, au cours de l'une des étapes suivantes, on répare les dommages provoqués par cette implantation.

4. Procédé selon la revendication 2, selon lequel, avant la première étape, on réalise, dans une couche proche de la surface du matériau semiconducteur (11), une zone de dopage (111) ayant un dopage prévu pour les régions de source et de drain (3), et entre les quatrième et cinquième étapes, on ménage une cavité (63) dans le matériau semiconducteur (11) dans la zone de la surface mise à nu (62), de sorte qu'en raison de la présence de cette cavité (63), l'épaisseur de la région de dopage (111) est réduite dans la zone de grille, d'une manière qui correspond à la différence de dopage entre la région de grille et les régions de source et de drain (3).

5. Procédé suivant l'une des revendications 1 à 4, selon lequel on forme l'élément de masquage (2) par voie photolithographique à partir d'une couche de vernis photosensible déposée sur toute la surface magnétique.

6. Procédé suivant l'une des revendications 1 à 4, dans lequel on forme l'élément de masquage (2) en déposant tout d'abord une couche de vernis photosensible sur toute la surface du matériau semiconducteur (1), en formant, dans cette couche de vernis photosensible, un évidement correspondant à la forme de l'élément de masquage (2), en déposant ensuite d'une manière anisotrope une couche auxiliaire sur la couche de vernis photosensible (31) structurée de cette manière, et en appliquant ensuite une rétrogravure isotrope à cette couche auxiliaire jusqu'à ce que seule subsiste une partie (34) correspondant à l'élément de masquage (2), après l'élimination de la couche de vernis photosensible (31), de la couche auxiliaire.
